# EUROPÄISCHE PATENTSCHRIFT

(11) **EP 4 012 426 B1**
(45) Veröffentlichungstag und Bekanntmachung des Hinweises auf die Patenterteilung: **06.09.2023**
(21) Anmeldenummer: 20213829.3
(22) Anmeldetag: 14.12.2020
(51) Int. Cl.: G01R 23/16

(54) **VERFAHREN ZUR KORREKTUR EINES ZEITABHÄNGIGEN MESSSIGNALS EINER MOTOR-GETRIEBEEINHEIT SOWIE VERFAHREN ZUR ERKENNUNG VON VERSCHLEISS UND/ODER EINER BESCHÄDIGUNG DERSELBEN MITTELS DIESES KORREKTURVERFAHRENS**
METHOD FOR CORRECTING A TIME-DEPENDENT MEASUREMENT SIGNAL OF AN ENGINE TRANSMISSION UNIT AND METHOD FOR DETECTING WEAR AND / OR DAMAGE OF SAME BY MEANS OF THIS CORRECTION METHOD
PROCÉDÉ DE CORRECTION D'UN SIGNAL DE MESURE DÉPENDANT DU TEMPS D'UNE UNITÉ D'ENGRENAGE ET DE MOTEUR AINSI QUE PROCÉDÉ DE DÉTECTION DE L'USURE ET/OU DES DOMMAGES DE CELLE-CI AU MOYEN DUDIT PROCÉDÉ DE CORRECTION

(43) Veröffentlichungstag der Anmeldung: 15.06.2022
(73) Patentinhaber: IMS Gear SE & Co. KGaA, 78166 Donaueschingen (DE)
(72) Erfinder: Werschler, Dr., Marco, 78315 Radolfzell am Bodensee (DE); Werschler, Dr., Florian, 78467 Rottweil (DE); MITTELBACH, Marcel, 79859 Schluchsee (DE); HAMBURGER, Florian, 72074 Tübingen (DE)
(74) Vertreter: Westphal, Mussgnug & Partner Patentanwälte mbB

(56) Entgegenhaltungen:
- CA-A1- 2 582 560
- DE-A1-102011 121 789
- US-A1- 2004 050 177

## Beschreibung

Die Erfindung betrifft ein Verfahren zur Korrektur eines zeitabhängigen Messsignals, welches mittels eines antriebsseitig mit einem Getriebe gekoppelten Motors, insbesondere Elektromotors, erzeugt wird. Die Korrektur erfolgt hinsichtlich des Einflusses einer variablen Abtriebslast und einer variablen Drehzahl auf das zeitabhängige Messsignal, um dadurch Messsignale von solchen unterschiedlichen Betriebszuständen vergleichbar zu machen. Die Erfindung betrifft ferner ein Verfahren zur Erkennung von Verschleiß und/oder einer Beschädigung einer Motor-Getriebeeinheit mit einem Elektromotor und einem abtriebsseitig mit demselben gekoppelten Getriebe mittels des Korrekturverfahrens.

Elektromechanische Antriebe, die aus einem Elektromotor und einem abtriebsseitigen Getriebe aufgebaut sind, erfahren eine zunehmende Bedeutung, insbesondere als Bestandteil größerer Einheiten, wie bspw. Fahrzeuge oder Fertigungsanlagen.

Für solche Anwendungen ist ein möglichst fehlerfreier Betrieb wünschenswert. Mechanische Schäden an solchen elektromechanischen Antrieben führen zu Ausfällen und unerwünschten Reparaturkosten. Zur Vermeidung derartiger Nachteile sollen bspw. auf Basis einer zeitabhängigen Zustandsüberwachung Schäden an Komponenten an solchen elektromechanischen Antrieben frühzeitig erkannt werden.

Ein solches Verfahren ist bspw. aus der DE 10 2016 222 660 A1 bekannt, bei welchem zum Erkennen von Schäden und/oder Verschleiß an translatorisch bewegten Teilen eines elektromechanischen Antriebs folgende Verfahrensschritte durchgeführt werden:
- Messen des dem elektrischen Antrieb zugeführten elektrischen Stroms,
- Durchführen einer Zeit-Frequenz-Analyse,
- Vergleichen des aus der Zeit-Frequenz-Analyse ermittelten Frequenzspektrums des gemessenen elektrischen Stroms mit einem vorgegebenen Frequenzspektrum, und
- Auslösen eines Fehlersignals, wenn aus dem Vergleich der beiden Frequenzspektren eine Abweichung vorgegebener Größe festgestellt wird.

Des Weiteren beschreibt die US 4 965 513 A ein Verfahren zur Überwachung der Betriebszustände eines elektrisch angetriebenen Ventils, indem eine Analyse des Motorstroms durchgeführt wird. Hierzu werden verschiedene Methoden der Frequenzanalyse auf den Motorstrom angewendet, um eine Rauschsignatur des Motorstroms zu erstellen, mittels welcher Verschleiß und abnormale Betriebszustände erkennbar sein sollen. Anhand der Rauschsignatur sollen unterschiedliche charakteristische Betriebszustände des elektrisch angetriebenen Ventils feststellbar sein, insbesondere könne die Summe aller mechanischen Lastwechsel detektierbar sein, die sich im Frequenzspektrum und den Amplituden manifestieren. Werden solche Rauschsignaturen in unterschiedlichen Zeitabschnitten während des Betriebs erstellt, sollen Alterung und Abnutzung oder abnormale Betriebszustände bestimmbar sein.

Darüber hinaus beschreibt die US 2004/050177 A1 ein Verfahren zum Analysieren des Zustands eines motorgetriebenen Getriebesystems unter Verwendung einer Stromwellenform, die von dem Motor erzeugt wird, wobei die Stromwellenform auf die Motordrehfrequenz normiert wird, um eine normierte Wellenform in der räumlichen Domäne zu definieren, und eine Frequenzanalyse an der normierten Wellenform durchgeführt wird.

Bei diesem Stand der Technik hat sich jedoch gezeigt, dass die Aufbereitung der Motorstromsignale unzureichend ist, um bei variierenden Betriebszuständen der Motor-Getriebeeinheit mit einem Elektromotor und einer abtriebsseitig mit demselben verbundenen Getriebe sichere Aussagen bzgl. Verschleiß und Beschädigungen zu treffen.

Es ist daher Aufgabe der Erfindung ein Verfahren zur Korrektur eines mittels eines abtriebsseitig mit einem Getriebe gekoppelten Elektromotors erzeugten zeitabhängigen Messsignals anzugeben, so dass eine Analyse des korrigierten Messsignals hinsichtlich Verschleiß und/oder einer Beschädigung gegenüber dem Stand der Technik zu besseren Ergebnissen führt.

Ferner ist es Aufgabe der Erfindung, auf der Basis des Korrekturverfahrens ein Verfahren zur Erkennung von Verschleiß und/oder einer Beschädigung einer Motor-Getriebeeinheit mit einem Elektromotor und einer abtriebsseitig mit demselben gekoppelten Getriebe anzugeben.

Die erstgenannte Aufgabe wird gelöst durch ein Verfahren mit den Merkmalen des Patentanspruchs 1.

Bei diesem Verfahren zur Korrektur eines mittels eines abtriebsseitig mit einem Getriebe gekoppelten Elektromotors erzeugten zeitabhängigen Messsignals hinsichtlich des Einflusses einer variablen Abtriebslast und einer variablen Drehzahl werden folgende Verfahrensschritte durchgeführt:
a) Abgreifen eines von einem Drehmoment der Motor-Getriebeeinheit (1) abhängigen Messsignals (M),
b) Erzeugen eines gleichanteilfreien Nutzsignals (N1) aus dem Messsignal (M),
c) intervallweises Bestimmen von Effektivwerten aus dem Messsignal (M),
d) Erzeugen eines lastkorrigierten Nutzsignals (N2) durch intervallweise Division des gleichanteilfreien Nutzsignals (N1) durch die intervallspezifischen Effektivwerte,
e) zeitaufgelöste Bestimmung der Drehfrequenz (f) des Motors (1) aus dem Messsignal (M),
f) Skalieren, insbesondere Normieren des lastkorrigierten Nutzsignals (N2) auf die eine mittlere Drehfrequenz zur Erzeugung eines korrigierten Messsignals (M_{corr}) mit Hilfe der bestimmten Drehfrequenz (f), indem einzelne Perioden des Nutzsignals (N2), die eine höhere Frequenz aufweisen, gestreckt, während Perioden mit niedriger Drehfrequenz gestaucht werden, und
g) Verwendung des korrigierten Messignals zur Fehlerdetektion oder Verschleißerkennung der Motor-Getriebeeinheit.

Ein solches Korrekturverfahren führt zu einer verbesserten Signalqualität, insbesondere zu einem verbesserten Signal-zu-Rausch-Verhältnis und zu einer besseren Vergleichbarkeit der korrigierten Messsignale bei unterschiedlichen Lasten, so dass auf das korrigierte Messsignal angewendete Analyseverfahren hinsichtlich Verschleiß und/oder Beschädigung der Motor-Getriebeeinheit zu aussagesicheren qualitativ besseren Ergebnissen führt.

Mit einem solchen korrigierten Messsignal können unterschiedliche Analyseverfahren, wie bspw. eine FFT-(Fast Fourier) Analyse oder Hüllkurvenanalyse im Frequenzbereich durchgeführt werden. Geeignete Analyseverfahren im Zeitbereich sind z. B. Ermittlungen von Kurtoris, Minimum,Maximum, RMS, Standardabweichungen, Mittelwerte oder Ähnliches.

Als Messsignal kann z.B. der Motorstrom analysiert werden, aber auch z.B. das Drehmoment oder jedes andere vom Drehmoment abhängige Signal.

Die zweitgenannte Aufgabe wird gelöst durch ein Verfahren zur Erkennung von Verschleiß und/oder einer Beschädigung einer Motor-Getriebeeinheit mit den Merkmalen des Patentanspruchs 2.

Bei diesem Verfahren zur Erkennung von Verschleiß und/oder einer Beschädigung einer Motor-Getriebeeinheit mit einem Elektromotor und einem abtriebsseitig mit demselben gekoppelten Getriebe werden folgende Verfahrensschritte durchgeführt:
- Erzeugen eines zeitabhängigen Messsignals mittels der Motor-Getriebeeinheit,
- Erzeugen eines korrigierten Messsignals gemäß des Verfahrens nach Anspruch 1,
- Bestimmen eines Frequenzspektrums mittels der FFT-(Fast Fourier) Analyse aus dem korrigierten Messsignal,
- Bereitstellen eines Referenz-Frequenzspektrums, welches mittels der FFT-Analyse aus einem korrigierten Messsignal einer verschleiß- und/oder schadensfreien Motor-Getriebe-einheit erzeugt wird, und
- Vergleichen des Frequenzspektrums des korrigierten Messsignals mit dem Referenz-Frequenzspektrum und
- Bestimmen von verschleißanzeigenden und/oder beschädigungsanzeigenden Merkmalen aus dem Vergleich des Frequenzspektrums des korrigierten Messsignals mit dem Referenz-Frequenzspektrum.

Mit der Analyse des korrigierten Messsignals im Frequenzbereich mittels der FFT-Analyse wird die Identifizierung bauteilspezifischer Merkmale der Motor-Getriebeeinheit, die sich durch Verschleiß und/oder Beschädigung in ihrer Ausprägung unterscheiden, ermöglicht.

So wird/werden weiterbildungsgemäß
- jeder Frequenzlinie des aus einem korrigierten Messsignal mittels der FFT-Analyse erzeugten Frequenzspektrums ein bauteilspezifisches Merkmal der Motor-Getriebeeinheit zugeordnet, und
- zur Bestimmung eines verschleißanzeigenden und/oder beschädigungsanzeigenden Merkmals die Amplituden und/oder das spektrale Integral identischer Frequenzlinien des Frequenzspektrums des korrigierten Messsignals und des Frequenzspektrums des Referenz-Frequenzspektrums verglichen.

Damit ist es möglich, das auf das korrigierte Messsignal angewendete Analyseverfahren automatisiert durchzuführen.

Nach einer vorteilhaften Weiterbildung der Erfindung wird Verfahrensschritt a) durchgeführt, indem ein Gleichanteil des Messsignals bestimmt und dieser vom Messsignal subtrahiert wird. Vorzugsweise wird hierbei zur Bestimmung des Gleichanteils des Messsignals das Messsignal tiefpassgefiltert. Mit der Beseitigung des Gleichanteils führt eine Frequenzanalyse des Messsignals zu einer verbesserten Signalqualität.

Gemäß einer weiteren bevorzugten Ausgestaltung der Erfindung werden die Verfahrensschritte b) und c) durchgeführt, indem
- das Messsignal in zeitlich aufeinanderfolgende Zeitabschnitte kleiner als ein vorgegebener Zeitwert unterteilt wird,
- für jeden Zeitabschnitt der intervallspezifische Effektivwert des Messsignals bestimmt wird, und
- zur Erzeugung des lastkorrigierten Nutzsignals in jedem Zeitabschnitt das gleichanteilfreie Nutzsignal durch den intervallspezifischen Effektivwert dividiert wird.

Der Zeitwert der Zeitabschnitte bestimmt sich nach der ermittelten antriebsseitigen Drehfrequenz sowie der zeitlichen Länge und/oder der Anzahl der Abtastpunkte des gemessenen zeitabhängigen Messsignals und beträgt bspw. 0,2 s.

Für das Korrekturverfahren gemäß Anspruch 1 als auch für das Analyseverfahren gemäß Anspruch 2 hat sich als besonders vorteilhaft herausgestellt, wenn als Messsignal ein den Motorstrom des Elektromotors der Motor-Getriebeeinheit anzeigendes Motorstromsignal erzeugt wird.

Falls weiterbildungsgemäß als Elektromotor ein Bürsten-Gleichstrommotor eingesetzt wird, lässt sich der Verfahrensschritt d) in besonders einfacher Weise durchführen, indem
- die Maxima des Motorstromsignals und deren Zeitwerte bestimmt werden,
- aus dem Abstand der Maxima des Motorstromsignals, der Nutenzahl und der Anzahl der Bürsten des Bürsten-GleichstromMotors die Drehfrequenz oder Bürstenfrequenz annähernd bestimmt wird,
- das Motorstromsignal im Bereich der annähernd bestimmten Drehfrequenz oder Bürstenfrequenz bandpassgefiltert wird,
- die Maxima aus dem bandpassgefilterten Motorstromsignal und deren Zeitwerte bestimmt werden, und
- aus dem Abstand der Maxima des bandpassgefilterten Motorstromsignals, der Nutenzahl und der Anzahl der Bürsten die Drehfrequenz oder Bürstenfrequenz des Bürsten-Gleichstrommotors bestimmt wird.

Die Erfindung wird nachfolgend anhand von Ausführungsbeispielen unter Bezugnahme auf die beigefügten Figuren ausführlich beschrieben. Es zeigen:
- Figur 1: eine schematische Darstellung eines Beispiels eines Systems zur Erkennung von Verschleiß und/oder Beschädigungen der Komponenten einer Motor-Getriebeeinheit,
- Figur 2: ein schematisches Zeit-Strom-Diagramm eines Motorstromsignals für eine Motor-Getriebeeinheit im Neuzustand und für eine einen Verschleiß aufweisende Motor-Getriebeeinheit,
- Figur 3: eine schematische Darstellung der Motorstromsignale gemäß Figur 2 im Frequenzbereich,
- Figur 4: eine schematische Darstellung eines Motorstromsignals mit und ohne Gleichanteil
- Figur 5: eine schematische Darstellung der Motorstromsignale gemäß Figur 4 im Frequenzbereich,
- Figur 6: ein Zeit-Strom bzw. Drehmoment-Diagramm mit dem zeitlichen Verlauf eines Motorstromsignals, dessen Gleichanteils und eines Drehmoments,
- Figur 7: ein Zeit-Strom-Diagramm mit einem zeitaufgelösten gleichanteilfreien und lastkorrigierten Nutzsignal,
- Figur 8: ein Diagramm mit dem zeitlichen Verlauf eines bandpassgefilterten Motorstromsignals,
- Figur 9: ein Zeit-Frequenz-Diagramm mit dem zeitlichen Verlauf einer aus Figur 8 bestimmten Bürstenfrequenz und einer auf Messwerten basierten, berechneten Bürstenfrequenz,
- Figur 10: ein Zeit-Strom-Diagramm mit dem zeitlichen Verlauf eines korrigierten Messsignals M_{corr} und dem zeitlichen Verlauf eines nicht korrigierten Messsignals M,
- Figur 11: ein Frequenzspektrum der in Figur 10 dargestellten Messsignale M_{corr} und M,
- Figur 12a: einen Ausschnitt eines FFT-Spektrums eines korrigierten Messsignals M_{corr} einer Motor-Getriebeeinheit mit einem Verzahnungsschaden und eines als Referenz dienenden korrigierten Messsignals einer intakten Motorgetriebeeinheit, und
- Figur 12b: eine ähnliche Darstellung wie in Figur 12a, jedoch ohne Korrektur der Messsignale.

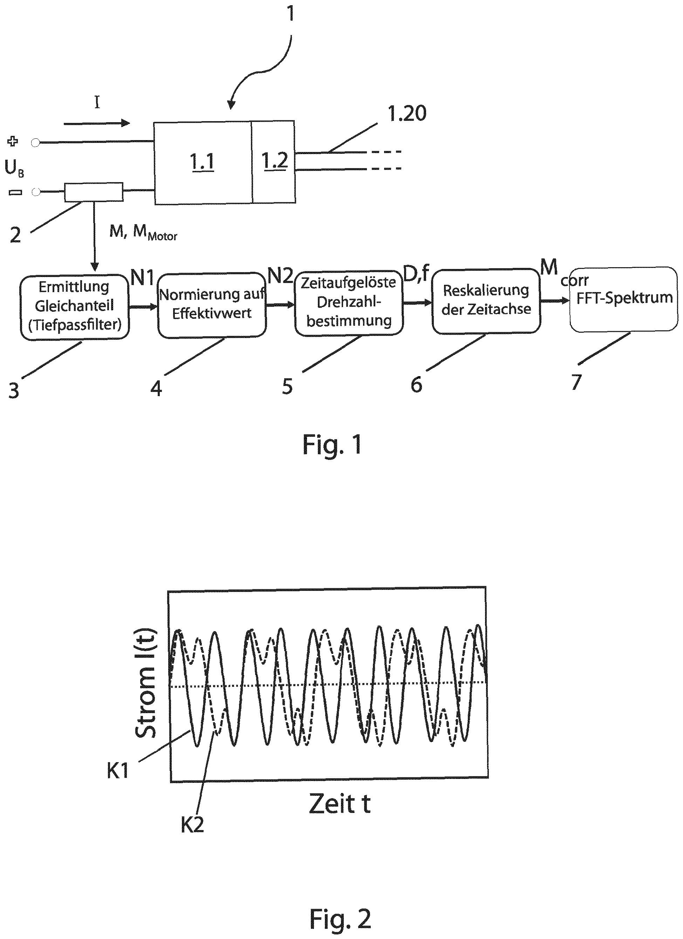

Die Figur 1 zeigt schematisch ein Beispiel für ein System bzw. eine Vorrichtung zur Erkennung von Verschleiß und/oder Beschädigungen von Komponenten einer Motor-Getriebeeinheit 1. Diese weist einen elektrischen Motor 1.1 und ein abtriebsseitig mit demselben verbundenes Getriebe 1.2 auf. Der Motor 1.1 ist vorzugsweise ein Elektromotor mit einer gegebenen Nutenzahl und einer gegebenen Bürstenzahl. Das Getriebe 1.2 weist eine Abtriebswelle 1.20 auf.

Im Betrieb der Motor-Getriebeeinheit 1 wird vorliegend eine Strommessung mittels einer Strommesseinheit 2 durchgeführt, die als Messsignal M ein zeitaufgelöstes Motorstromsignal M_{Motor} des dem elektrischen Motor 1.1 zugeführten Motorstroms I liefert.

Die Figur 2 zeigt schematisch zwei Beispiele des zeitlichen Verlaufs des zeitabhängigen Motorstromsignals einer Motor-Getriebeeinheit 1 in unterschiedlichen Betriebszuständen.

Die Kurve K1 (durchgezogene Linie) zeigt ein Motorstromsignal im Zeitbereich für eine Motor-Getriebeeinheit 1 im Neuzustand, d. h. bei einer solchen Motor-Getriebeeinheit 1 weist keine der beiden Komponenten Elektromotor 1.1 und Getriebe 1.2 weder eine Beschädigung noch einen Verschleiß auf.

Die Kurve K2 (gestrichelte Linie) zeigt ein Motorstromsignal im Zeitbereich für eine Motor-Getriebeeinheit 1, deren Komponenten, also der Elektromotor 1.1 und/oder das Getriebe 1.2 einen Verschleiß und/oder eine Beschädigung aufweist/aufweisen.

In dem unterschiedlichen zeitlichen Verlauf der beiden Motorstromsignale gemäß den Kurven K1 und K2 manifestieren sich unterschiedliche Betriebszustände der Motor-Getriebeeinheit 1, nämlich einen Betriebszustand der Motor-Getriebeeinheit 1 im Neuzustand und einen Betriebszustand der einen Verschleiß und/oder eine Beschädigung aufweisende Motor-Getriebeeinheit 1. Mittels einer Frequenzanalyse dieser zeitabhängigen Motorstromsignale lassen sich verschleiß- und/oder schadensspezifische Merkmale erkennen und damit eine vorausschauende Wartung einer Motor-Getriebeeinheit 1 realisieren. Voraussetzung hierfür ist jedoch, dass die Werte aus der Frequenzanalyse bei unterschiedlichen Betriebszuständen der Motor-Getriebeeinheit 1 betreffend einer variierenden Abtriebslast und einer variierenden Drehzahl vergleichbar sind.

Um die Vergleichbarkeit der zeitabhängigen Messsignale bei unterschiedlichen Betriebszuständen der Motor-Getriebeeinheit 1 zu gewährleisten, wird das Motorstromsignal M_{Motor} als zeitabhängiges Messsignal M einem Korrekturverfahren unterzogen, bevor das solchermaßen korrigierte Messsignal M_{corr} z.B. einer FFT-(Fast Fourier-Transformation) Frequenzanalyse unterzogen wird.

Hierbei zeigt die Figur 1 grundsätzliche Blöcke 3 bis 6 als Verfahrensschritte zur Durchführung des Korrekturverfahrens für das Motorstromsignal M_{Motor} als zeitabhängiges Messsignal M, welches mittels einer Messeinheit 2 zur Messung des Motorstroms I des Elektromotors 1.1 bereitgestellt wird. Die einzelnen Verfahrensschritte gemäß den Blöcken 3 bis 6 werden weiter unten im Detail erläutert.

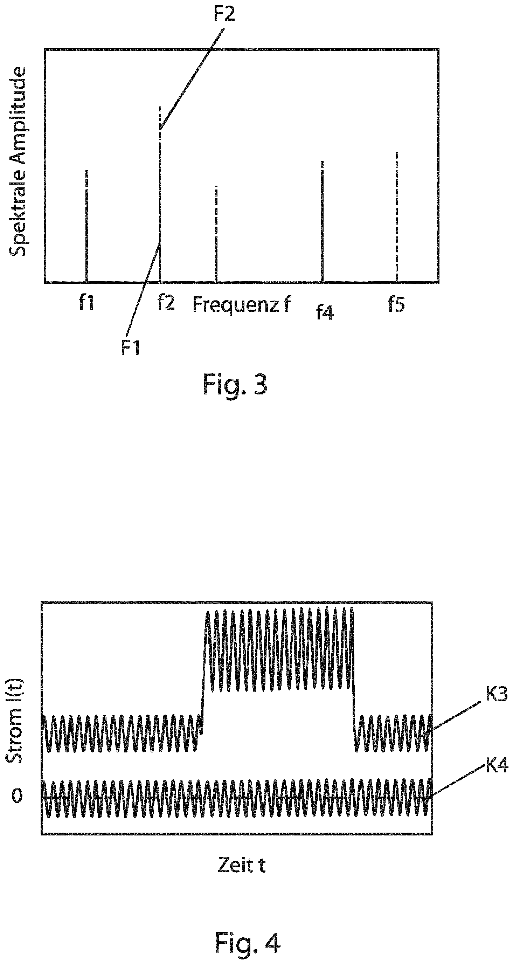

Das mit dem Verfahrensschritt gemäß Block 6 erzeugte korrigierte Messsignal M_{corr} wird einem Block 7 zur FFT-Frequenzanalyse und zur Erzeugung eines Frequenzspektrums zugeführt. Ein solches Frequenzspektrum mit Frequenzlinien F1 (durchgezogene Linien) und F2 (gestrichelte Linien) zeigt beispielhaft Figur 3, die schematisch aus dem Motorstromsignal gemäß den Kurven K1 und K2 erzeugt sind.

So zeigt Figur 3 fünf Spektrallinien f1 bis f5, wobei die Frequenzen der Spektrallinien f1 bis f4 identisch für beide Motorstromsignale gemäß den Kurven K1 und K2 sind, jedoch mit unterschiedlichen Amplitudenausprägungen, während die Spektrallinie f5 dem Motorstromsignal gemäß der Kurve K2 zugeordnet ist.

Jede dieser Spektrallinien f1 bis f4 kann einem spezifischen mechanischen Merkmal der Motor-Getriebeeinheit 1 zugeordnet werden, wobei der Wert der Amplitude und/oder das spektrale Integral den Betriebszustand repräsentiert. Somit zeigen die F1-Spektrallinien f1 bis f4 einen betriebsgemäßen Zustand der Motor-Getriebeeinheit 1 an, die also weder einen Verschleiß noch eine Beschädigung aufweist. Die F2-Spektrallinie f5 zeigt eine Beschädigung der Motor-Getriebeeinheit 1 an.

f1 könnte beispielsweise die Abtriebsfrequenz darstellen, f2 die Drehfrequenz der Planeten höherer Stufe, f3 selbige erster Stufe, f4 die Antriebsfrequenz, und f5 eine Fehlerüberrollfrequenz der Planeten erster Stufe.

Aus Figur 3 folgt auch, dass das Frequenzspektrum des korrigierten Messsignals M_{corr} des Messsignals gemäß Kurve K1 mit dem Frequenzspektrum des korrigierten Messsignals gemäß Kurve K2 verglichen werden kann und aus dem Vergleichsergebnis der aktuelle Betriebszustand der Motor-Getriebeeinheit 1 hinsichtlich Verschleiß und Beschädigungen ableitbar ist. Ferner kann auch eine Trendkurve der verscheiß- und/oder schadensspezifischen Merkmalen ermittelt werden, indem während zeitlich aufeinanderfolgenden Betriebsintervallen solche Frequenzspektren erstellt werden.

Im Folgenden wird das auf ein Motorstromsignal M_{Motor} als Messsignal M angewendete Korrekturverfahren gemäß den Blöcken 3 bis 6 (vgl. Figur 1) erläutert, welches anschließend dem Block 7 zur Frequenzanalyse und Erstellung eines Frequenzspektrums zugeführt wird.

Um eine Vergleichbarkeit der Frequenzspektren bei unterschiedlichen Betriebszuständen der Motor-Getriebeeinheit 1 zu gewährleisten, müssen die Einflüsse durch die variierende Abtriebslast des Elektromotors 1.1 und die variierende Drehzahl des Elektromotors 1.1 eliminiert werden.

Zunächst soll der Einfluss einer variierenden Abtriebslast auf das Motorstromsignal M_{Motor} korrigiert werden.

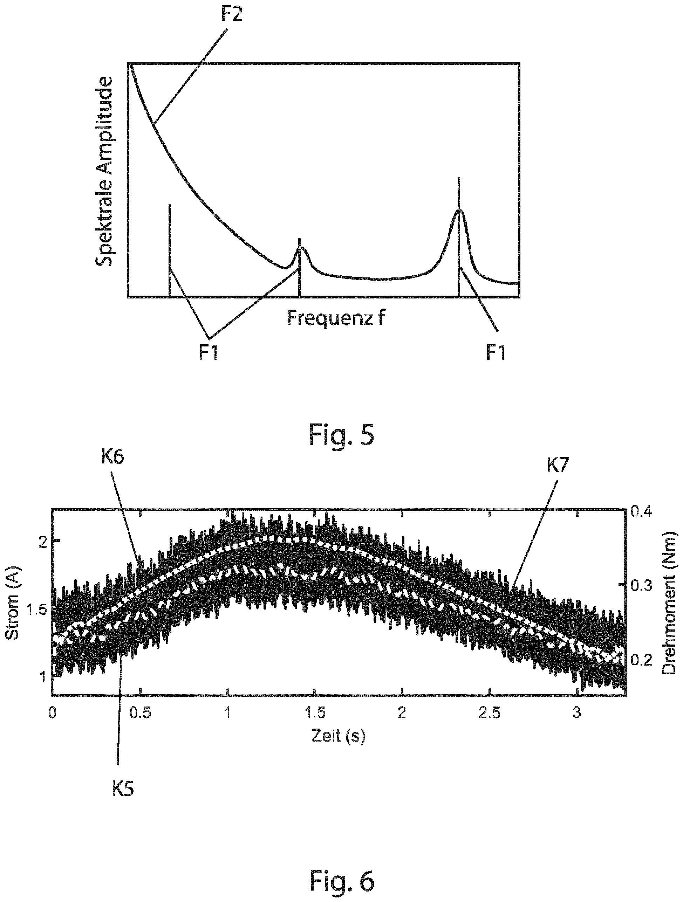

Aufgrund einer schwankenden Abtriebslast an dem Elektromotor 1.1 während eines Messvorganges verändert sich der Gleichanteil des Motorstromsignals M_{Motor} in Abhängigkeit der Zeit, wie dies in Figur 4 durch die Kurve K3 dargestellt ist. Ohne das erfindungsgemäße Korrekturverfahren führt eine Frequenzanalyse zu einem Frequenzspektrum F2 gemäß Figur 5, bei welchem der niederfrequente Bereich stark von einem exponentiell abfallenden Signal überlappt wird. Zum Vergleich zeigt Figur 5 das Frequenzspektrum F1 eines Motorstromsignals M_{Motor} bei welchem der Gleichanteil entsprechend der Kurve K4 eliminiert ist. Bei diesem Frequenzspektrum F1 sind die Spektrallinien klar und eindeutig ausgeprägt, während das Frequenzspektrum F2 im niederfrequenten Bereich nicht auswertbar ist. Damit ist die Eliminierung des Gleichanteils aus dem Motorstromsignal M_{Motor} essenziell für eine FFT-Analyse.

Daher wird in einem ersten Verfahrensschritt gemäß Block 3 (vgl. Figur 1) zunächst der Gleichanteil des Motorstromsignals M_{Motor} bestimmt, indem dieses zunächst mit einem Tiefpassfilter mit einer Grenzfrequenz von kleiner als 1 Hz tiefpassgefiltert wird. Das derart erzeugte Signal S_{gleich} entspricht der Kurve K5 gemäß Figur 6, welches näherungsweise dem Gleichanteil des Motorstromsignals M_{Motor} entspricht, wobei mit K6 das Motorstromsignal M_{Motor} bezeichnet ist und die Kurve K7 zum Vergleich das zeitaufgelöste Abtriebsdrehmoment der Motor-Getriebeeinheit zeigt.

Mit dem derart erzeugten Signal S_{gleich} wird ein gleichanteilfreies Nutzsignal N1 aus dem Motorstromsignal M_{Motor} bestimmt, indem das Signal S_{gleich} von dem Motorstromsignal M_{Motor} vektoriell subtrahiert wird.

Der Gleichanteil gemäß des Signals S_{gleich} folgt dem Verlauf des anliegenden Abtriebs- bzw. Lastmoments entsprechend der Kurve K7 gemäß Figur 6. Aufgrund der variierenden Abtriebslast verändern sich auch die Amplituden der Stromschwankungen des Motorstromsignals M_{Motor} bedingt durch die Rotation der einzelnen Getriebebauteile, wie dies anhand der Kurve K3 gemäß Figur 4 ersichtlich ist.

Um diese Amplitudenschwankungen des Motorstromsignals M_{Motor} zu eliminieren, wird eine Normierung des gleichanteilfreien Nutzsignals N1 auf den Effektivwert (vgl. Figur 1, Block 4) durchgeführt.

Hierzu wird das zeitaufgelöste gleichanteilfreie Nutzsignal N1 in kurze aufeinanderfolgende Zeitabschnitte mit einem vorgegebenen Zeitwert, bspw. von kleiner als 0,2 s unterteilt und für diese Zeitabschnitte ein intervallspezifischer Effektivwert berechnet. Hierzu wird das Signal z.B. in einzelne Teile adäquater Länge eingeteilt (ungefähr 0,05s - 0,2s, fester aber frei wählbarer Wert). An die einzelnen Effektivwerte wird eine Smoothline angepasst, wodurch ebenfalls ein resampling des Zahlenvektors der Effektivwerte (gleiche Sampleanzahl als Messsignal) stattfindet. Im Anschluss werden die beiden Zahlenvektoren punktweise dividiert. Mit diesen intervallspezifischen Effektivwerten wird jeder Zeitabschnitt des gleichanteilfreien Nutzsignals N1 durch den zugehörigen intervallspezifischen Effektivwert dividiert. Mit dem dadurch erhaltenen lastkorrigierten Nutzsignal N2 sind die Signalamplituden normiert, wodurch eine Vergleichbarkeit verschiedener Motorstromsignale M_{Motor} gewährleistet wird.

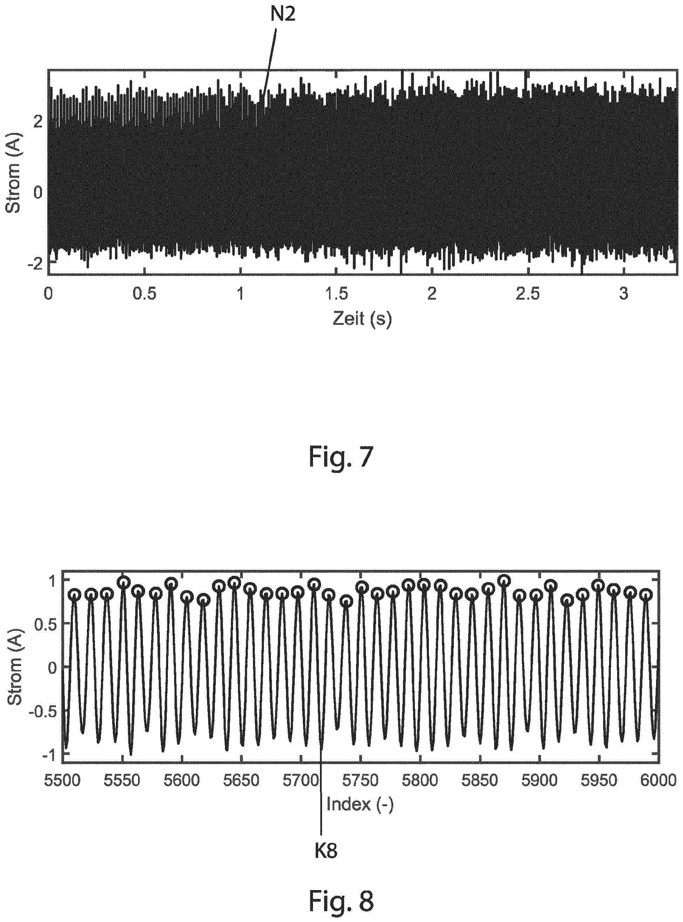

Das zeitaufgelöste Nutzsignal N2 zeigt gemäß Figur 7 weder Gleichanteile noch Effektivwertabweichungen.

Wie bereits oben ausgeführt, beeinflusst zusätzlich zur Abtriebslast auch die Antriebsdrehzahl, also die Drehzahl des Elektromotors 1.1 die Signalqualität und -ausprägung des Motorstromsignals M_{Motor}.

Daher wird in einem nächsten Verfahrensschritt der zeitliche Verlauf der Drehzahl des Elektromotors 1.1 bestimmt (vgl. Block 5, Figur 1). Hierzu werden zunächst die Maxima sowie die zugehörigen Zeitwerte aus dem Motorstromsignal M_{Motor} bestimmt. Die zeitliche Differenz dieser absoluten Maxima entspricht im Falle eines Gleichstrommotors der inversen Bürstenfrequenz. Folglich werden die Zeitpunkte der lokalen Maxima des zeitaufgelösten Motorstromsignals ermittelt. Aus dem inversen zeitlichen Abstand zweier aufeinanderfolgender Maxima wird jeweils ein Frequenzwert berechnet. Aus dem Mittelwert aller dieser Frequenzwerte erhält man die ungefähre Bürstenfrequenz, vorausgesetzt (was meistens der Fall ist) die Bürste verursacht die Maxima im Zeitsignal. Aus dieser ungefähren Bürstenfrequenz, kann mit Hilfe der Anzahl der Bürsten und Nuten dann die ungefähre Drehzahl bestimmt werden. Dieser Schritt ist aber nicht notwendig, weil die Drehzahlnormierung des Signals auch über die Bürstenfrequenz erfolgen kann.

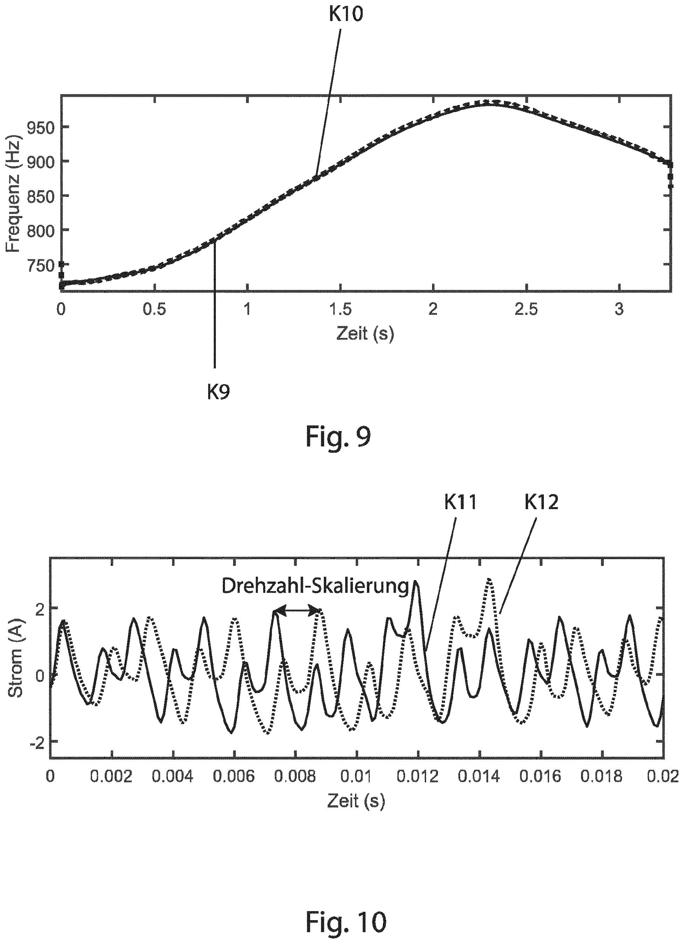

Zur Bestimmung der tatsächlichen Drehzahl d bzw. der tatsächlichen Drehfrequenz f des Elektromotors 1.1 wird eine Bandpassfilterung des Nutzsignals N2 (vgl. Figur 7) im Bereich der ungefähren Bürstenfrequenz durchgeführt. Dabei liegen die Grenzfrequenzen etwa + - 15% zur Bürstenfrequenz. Das bandpassgefilterte Nutzsignal N2 zeigt die in Figur 8 dargestellte Kurve K8. Aus dem zeitlichen Abstand der absoluten Maxima (in Figur 8 kreisförmig markiert) der Kurve K8 wird die tatsächliche Bürstenfrequenz berechnet. Durch Division der Anzahl der Bürsten und der Anzahl der Nuten ergibt sich hieraus die Drehfrequenz f bzw. die tatsächliche Drehzahl d. Hierzu wird ein Zahlenvektor bestehend aus den zeitlichen Abständen der Maxima erhalten. Durch das Anpassen einer Spline oder einem ähnlichen Verfahren sowie einem resampling auf die gleiche Sampleanzahl wie das Messsignal erhält man einen funktionalen Verlauf mit dem die Zeitachse des Messsignals skaliert, insbesondere normiert wird. Die Kurve K9 (durchgezogene Linie) der Figur 9 zeigt den zeitlichen Verlauf der aus dem zeitlichen Abstand der absoluten Maxima der Kurve K8 berechneten Bürstenfrequenz. Im Vergleich hierzu ist die aus der gemessenen Drehfrequenz berechnete Bürstenfrequenz als Kurve K10 (gestrichelte Linie) dargestellt. Beide Kurven K9 und K10 zeigen eine hohe Übereinstimmung. Anzumerken ist, dass die Drehfrequenz auch ohne die vorherige Bestimmung der Bürstenfrequenz ermittelt werden kann. Hierzu erfolgt die Bandpassfilterung direkt im Bereich der zuvor grob bestimmten Drehfrequenz.

Mit Hilfe der bestimmten zeitabhängigen Drehfrequenz f (vgl. Figur 9) erfolgt eine Normierung bzw. Skalierung der Zeitachse des in Figur 7 dargestellten lastkorrigierten Nutzsignals N2 in einem Verfahrensschritt gemäß des Blocks 6 (vgl. Figur 1) auf eine mittlere Drehfrequenz. Dabei werden einzelne Perioden des Nutzsignals N2, die eine höhere Frequenz aufweisen, gestreckt, während Perioden mit niedriger Drehfrequenz gestaucht werden. Mit diesem Normierungsschritt bzw. Skalierungsschritt wird aus dem lastkorrigierten Nutzsignal N2 das korrigierte Motorstromsignal, also das korrigierte Messsignal M_{corr} erzeugt, welches zur Erzeugung eines Frequenzspektrums mittels einer FFT-Frequenz-analyse dem Block 7 gemäß Figur 1 zugeführt wird.

Figur 10 zeigt das korrigierte Messsignal M_{corr} als Kurve K11 (durchgezogene Linie) und im Vergleich hierzu die Kurve K12 (gestrichelte Linie) des nicht korrigierten Motorstromsignals M_{Motor} bzw. Messsignals M.

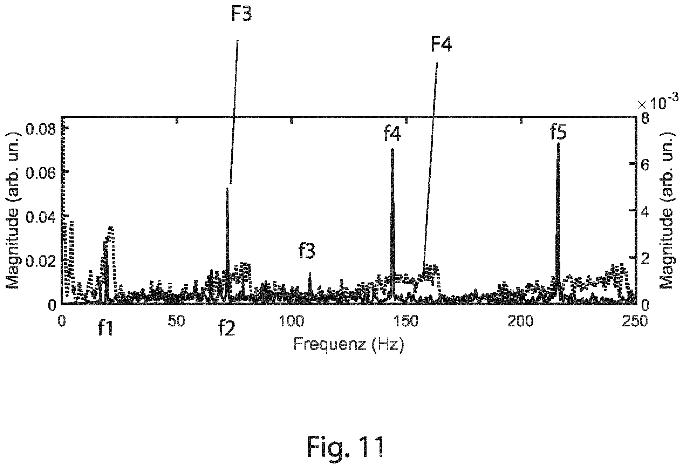

Wie bereits mehrfach ausgeführt, wird das korrigierte Messsignal M_{corr} einer FFT-Frequenzanalyse unterzogen und ein FFT-Spektrum F3 (vgl. Figur 11, durchgezogene Linie) erzeugt. Im Vergleich hierzu zeigt die Figur 11 ein FFT-Spektrum F4 (gestrichelte Linie) des nicht korrigierten Messsignals M.

Das FFT-Spektrum F3 des korrigierten Messsignals M_{corr} zeigt scharf ausgeprägte Maxima, die einzelnen charakteristischen Getriebemerkmalen und/oder Motormerkmalen eindeutig zugeordnet werden können und folglich als Grundlage für die Schadens- und Verschleißermittlung dienen. Diese als Spektrallinien scharf ausgeprägten Maxima können deutlich vom Rauschuntergrund unterschieden werden. Das Frequenzspektrum F3 zeigt fünf Spektrallinien f1 bis f5, die z.B. eindeutig folgenden Getriebemerkmalen bzw. Motormerkmalen zugeordnet werden. Drehfrequenzen einzelner Zahnräder, Fehlerüberrollfrequenzen, An- und Abtriebsdrehfrequenzen etc. Mit anderen Worten kann jede ausgeprägte Spektallinie f1 bis f5 einer ganz bestimmten Motor- oder Getriebekomponente oder deren Verhalten zugeordnet werden..

Werden jeweils nach einer unterschiedlichen Anzahl von Betriebsstunden solche FFT-Spektren F3 erzeugt, sind die jeweiligen Amplituden und/oder spektralen Integrale vergleichbar trotz unterschiedlicher Abtriebslasten des Getriebes 1.2 und unterschiedlichen Drehzahlen des Elektromotors 1.1 einer Motor-Getriebeeinheit 1.

Wird das FFT-Spektrum F4 des nicht korrigierten Messsignals M nach Figur 11 mit dem FFT-Spektrum des korrigierten Messsignals M_{corr} verglichen, zeigt sich, dass aufgrund der variierenden Abtriebslast des Getriebes 1.2 und der variierenden Drehzahl des Elektromotors 1.1 keine scharfen Maxima zu erkennen sind. Vielmehr verschwinden schwach ausgeprägte Merkmale im Untergrundrauschen. Ferner sind stark ausgeprägte Merkmale aufgrund der Drehzahlschwankungen stark ausgeschmiert und es kann keine eindeutige Frequenzzuordnung und folglich auch keine Komponenten spezifische Merkmalidentifizierung erfolgen.

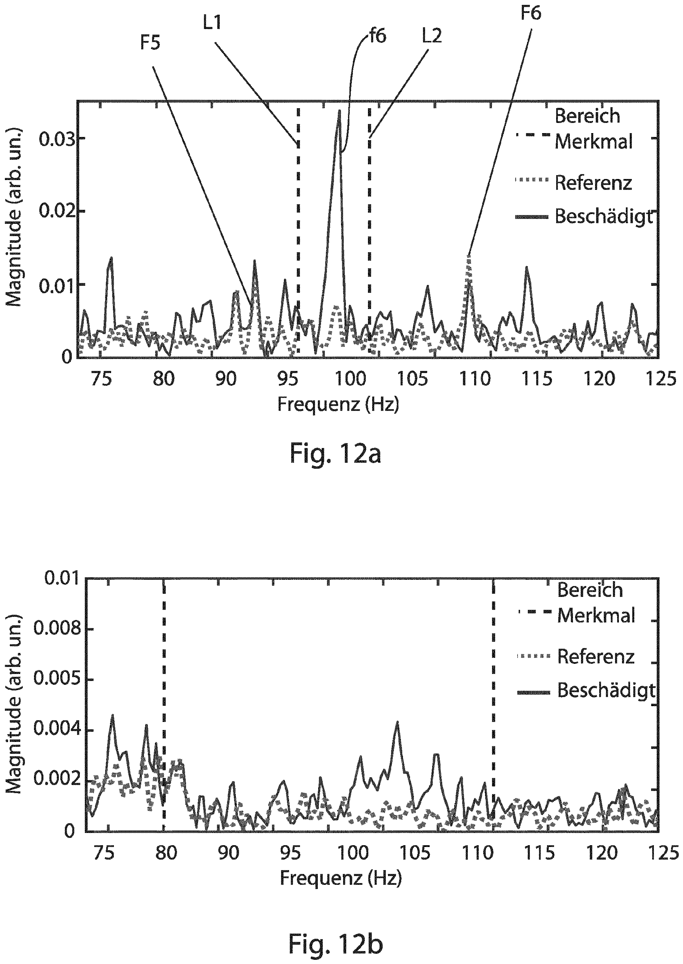

Die Figur 12a zeigt beispielhaft einen Ausschnitt eines FFT-Spektrums F5 eines korrigierten Motorstromsignals als korrigiertes Messsignals M_{corr} eines einen Verzahnungsschaden an einem Planetenrad eines als Planetengetriebe ausgebildeten Getriebes 1.2 einer Motor-Getriebeeinheit 1 im Frequenzbereich. Das schadenspezifische Merkmal ist zwischen den Linien L1 und L2 als ausgeprägte Spektrallinie f6 erkennbar. Die Strichlinie F6 zeigt als Referenz ein korrigiertes Signal einer intakten Motor-Getriebeeinheit.

Figur 12b zeigt im Vergleich hierzu das nicht gemäß dem vorbekannten Verfahren das Motorstromsignal im unkorrigierten Zustand im Vergleich zu einer Referenz einer intakten Motor-Getriebeeinheit. Figur 12b zeigt dabei das beschädigte Getriebe bei variabler Last und Drehzahl im Bereich der Fehlerüberrollfrequenz einer Planetenstufe. Sowohl der Bereich für diese Frequenz (schwarze Strichlinie), als auch die Amplituden sind sehr stark ausgeschmiert, sodass kein sinnvoller Vergleich erfolgen kann. Die punktierte Strichlinie stellt das unkorrigierte Signal aus Figur 11 dar und dient hier als Referenz. Die Figur 12a zeigt den korrigierten Fall nach dem vorliegenden Verfahren.

Mit diesem erfindungsgemäßen Korrekturverfahren verbessert sich nicht nur deutlich das Signal-zu-Rausch-Verhältnis, sondern es verkleinert sich auch wesentlich die Bandbreite über die sich verschleiß- und/oder schadenspezifische Merkmale erstrecken. Diese beiden positiven Eigenschaften prädestiniert das erfindungsgemäße Korrekturverfahren für eine reale Anwendung auf Motor-Getriebeeinheiten bei variierenden Umgebungsanforderungen.

In den oben beschriebenen Ausführungsbeispielen erfasst das Messsignal M als Motorstromsignal M_{Motor} den Verlauf des Motorstromes I des Elektromotors 1.1 der Motor-Getriebeeinheit 1 (vgl. Figur 1). Das Messsignal M kann auch in anderer Weise erzeugt werden, bspw. als Audiosignal mittels eines Mikrofons, mittels eines an der Motor-Getriebeeinheit 1 angeordneten Beschleunigungssensors, Drehmomentsensors, oder Ähnliches.

Es liegt im Rahmen der vorliegenden Erfindung, dass mit der Auswertung des Messsignales, also insbesondere beispielsweise des Motorstromes, ein sich abzeichnender Verschleiß oder eine sich abzeichnende Beschädigung der Motor-Getriebeeinheit detektierbar ist. Dies kann dazu genutzt werden, in einer Anzeigeeinrichtung eine für die Motor-Getriebeeinheit noch mögliche Lebensdauer anzugeben, bis wann die Motor-Getriebeeinheit noch weitgehend fehlerfrei in Betrieb gelassen werden kann. Darüber hinaus können über die Anzeigeeinrichtung auch Warnsignale abgegeben werden, sobald ein bestimmtes Verschleißbild anhand der erworbenen Messsignale festgestellt worden ist.

Angewendet kann das erfindungsgemäße Verfahren beispielsweise in Aktoren für Kraftfahrzeuge, bei Produktionsmaschinen, Roboter oder Ähnlichem.

## Patentansprüche

1. Verfahren zur Korrektur eines mittels eines abtriebsseitig mit einem Getriebe (1.2) gekoppelten Motors (1.1) erzeugten zeitabhängigen Messsignals (M) hinsichtlich des Einflusses einer variablen Abtriebslast und einer variablen Drehzahl, indem folgende Verfahrensschritte durchgeführt werden:
a) Abgreifen eines von einem Drehmoment der Motor-Getriebe-einheit (1) abhängigen Messsignals (M),
b) Erzeugen eines gleichanteilfreien Nutzsignals (N1) aus dem Messsignal (M),
c) intervallweises Bestimmen von Effektivwerten aus dem Messsignal (M),
d) Erzeugen eines lastkorrigierten Nutzsignals (N2) durch intervallweise Division des gleichanteilfreien Nutzsignals (N1) durch die intervallspezifischen Effektivwerte,
e) zeitaufgelöste Bestimmung der Drehfrequenz (f) des Motors (1) aus dem Messsignal (M),
f) Skalieren des lastkorrigierten Nutzsignals (N2) auf eine mittlere Drehfrequenz zur Erzeugung eines korrigierten Messsignals (M_{corr}) mit Hilfe der bestimmten Drehfrequenz (f), indem einzelne Perioden des Nutzsignals (N2), die eine höhere Frequenz aufweisen, gestreckt, während Perioden mit niedriger Drehfrequenz gestaucht werden, und
g) Verwendung des korrigierten Messsignals zur Fehlerdetektion der Motor-Getriebeeinheit.

2. Verfahren zur Erkennung von Verschleiß und/oder einer Beschädigung einer Motor-Getriebeeinheit (1) mit einem Motor (1.1) und einem abtriebsseitig mit demselben gekoppelten Getriebe (1.2), indem folgende Verfahrensschritte durchgeführt werden:
- Erzeugen eines zeitabhängigen Messsignals (M) mittels der Motor-Getriebeeinheit (1),
- Erzeugen eines korrigierten Messsignals (M_{corr}) gemäß dem Verfahren nach Anspruch 1,
- Bestimmen eines Frequenzspektrums (F3, F5) mittels einer FFT-(Fast Fourier) Analyse aus dem korrigierten Messsignal (M_{corr}),
- Bereitstellen eines Referenz-Frequenzspektrums, welches mittels der FFT-Analyse aus einem korrigierten Messsignal einer verschleiß- und/oder schadensfreien Motor-Getriebe-einheit erzeugt wird, und
- Vergleichen des Frequenzspektrums (F3, F5) des korrigierten Messsignals (M_{corr}) mit dem Referenz-Frequenzspektrum und
- Bestimmen von verschleißanzeigenden und/oder beschädigungsanzeigenden Merkmalen aus dem Vergleich des Frequenzspektrums des korrigierten Messsignals (F3, F5) mit dem Referenz-Frequenzspektrum, Signalisierung eines sich abzeichnenden Verschleißes oder einer sich abzeichnenden Beschädigung.

3. Verfahren nach Anspruch 2, bei welchem
- jeder Frequenzlinie des aus einem korrigierten Messsignal mittels der FFT-Analyse erzeugten Frequenzspektrums ein bauteilspezifisches Merkmal der Motor-Getriebeeinheit zugeordnet wird, und
- zur Bestimmung eines verschleißanzeigenden und/oder beschädigungsanzeigenden Merkmals die Amplituden und/oder das spektrale Integral identischer Frequenzlinien des Frequenzspektrums des korrigierten Messsignals und des Frequenzspektrums des Referenz-Frequenzspektrums verglichen werden.

4. Verfahren nach einem der vorhergehenden Ansprüche, bei welchem Verfahrensschritt a) durchgeführt wird, indem
- ein Gleichanteil des Messsignals (M) bestimmt wird, und
- der Gleichanteil vom Messsignal (M) subtrahiert wird.

5. Verfahren nach Anspruch 4, bei welchem zur Bestimmung des Gleichanteils des Messsignals das Messsignal tiefpassgefiltert wird.

6. Verfahren nach einem der vorhergehenden Ansprüche, bei welchem die Verfahrensschritte b) und c) durchgeführt werden, indem
- das Messsignal (M) in zeitlich aufeinanderfolgende Zeitabschnitte kleiner als ein vorgegebener Zeitwert unterteilt wird,
- für jeden Zeitabschnitt der intervallspezifische Effektivwert des Messsignals (M) bestimmt wird, und
- zur Erzeugung des lastkorrigierten Nutzsignals (N2) in jedem Zeitabschnitt das gleichanteilfreie Nutzsignal (N2) durch den intervallspezifischen Effektivwert dividiert wird.

7. Verfahren nach einem der vorhergehenden Ansprüche, bei welchem als zeitabhängiges Messsignal (M) ein den Motorstrom (I) des Elektromotors (1.1) der Motor-Getriebeeinheit (1) anzeigendes Motorstromsignal (M_{Motor}) erzeugt wird.

8. Verfahren nach Anspruch 7, bei welchem der Verfahrensschritt e) durchgeführt wird, indem
- die Maxima des Motorstromsignals (M_{Motor}) und deren Zeitwerte bestimmt werden,
- aus dem Abstand der Maxima des Motorstromsignals (M_{Motor}), der Nutenzahl und der Anzahl der Bürsten des Bürsten-Gleichstrommotors die Drehfrequenz (f₀) oder Bürstenfrequenz annähernd bestimmt wird,
- das Motorstromsignal (M_{Motor}) im Bereich der annähernd bestimmten Drehfrequenz (f₀) oder Bürstenfrequenz bandpassgefiltert wird,
- die Maxima aus dem bandpassgefilterten Motorstromsignal und deren Zeitwerte bestimmt werden, und
- aus dem Abstand der Maxima des bandpassgefilterten Motorstromsignals, der Nutenzahl und der Anzahl der Bürsten die Drehfrequenz (f) des Bürsten-Gleichstrommotors bestimmt wird.

9. Vorrichtung zur Erkennung von Verschleiß und/oder einer Beschädigung einer Motor-Getriebeeinheit (1), welche eine Verarbeitungseinrichtung aufweist, die zur Durchführung der in einem der Ansprüche 2 bis 8 genannten Verfahrensschritte eingerichtet ist.

## Claims

1. Method for the correction of a time-dependent measurement signal (M), generated by means of a motor (1.1), coupled on the output side to a transmission (1.2), with respect to the effect of a variable operational load and a variable rpm, in which the following method steps are carried out:
a) tapping a measurement signal (M) dependent on the torque of the motor-transmission unit (1),
b) generating a direct component-free useful signal (N1) from the measurement signal (M),
c) determining, in intervals, effective values from the measurement signal (M),
d) generating a load-corrected useful signal (N2) by means of dividing in intervals the direct component-free useful signal (N1) by the interval-specific effective values,
e) time-resolved determining of the rotational frequency (f) of the motor (1) from the measurement signal (M),
f) scaling the load-corrected useful signal (N2) to a medium rotational frequency for the generation of a corrected measurement signal (M_{corr}) with the aid of the determined rotational frequency (f), in that individual periods of the useful signal (N2) which exhibit a higher frequency are extended, while periods with a lower rotational frequency are compressed, and
g) using the corrected measurement signal to detect errors in the motor-transmission unit.

2. Method for the detection of wear and/or damage in a motor-transmission unit (1) with a motor (1.1), coupled on the output side with a transmission (1.2), in which the following method steps are carried out:
- generating a time-dependent measurement signal (M) by means of the motor-transmission unit (1),
- generating a corrected measurement signal (M_{corr}) using the method in accordance with claim 1,
- determining a frequency spectrum (F3, F5), by means of an FFT (Fast Fourier) analysis, from the corrected measurement signal (M_{corr}),
- providing a reference frequency spectrum which is generated, by means of the FFT analysis, from a corrected measurement signal of a wear and/or damage-free motor-transmission unit, and
- comparing the frequency spectrum (F3, F5) of the corrected measurement signal (M_{corr}) with the reference frequency spectrum and
- identifying, from the comparison of the frequency spectrum (F3, F5) of the corrected measurement signal (M_{corr}) with the reference frequency spectrum, features that show wear and/or damage and which indicate an impending wear or impending damage.

3. Method in accordance with claim 2, in which
- a component-specific feature of the motor-transmission unit is assigned to each frequency line of the frequency spectrum generated from a corrected measurement signal by means of the FFT analysis, and
- in order to identify a feature indicating wear and/or damage, the amplitudes and/or the spectral integral of identical frequency lines of the frequency spectrum of the corrected measurement signal and of the frequency spectrum of the reference frequency spectrum are compared.

4. Method in accordance with any of the preceding claims, in which the method step a) is carried out by
- determining a direct component of the measurement signal (M), and
- subtracting the direct component from the measurement signal (M).

5. Method in accordance with claim 4, in which, in order to determine the direct component of the measurement signal, the measurement signal is low-pass filtered.

6. Method in accordance with any of the preceding claims, in which the method steps b) and c) are carried out by
- dividing the measurement signal (M) into temporally successive time periods smaller than a specified time value,
- determining, for each time period, the interval-specific effective value of the measurement signal (M), and
- in order to generate the load-corrected useful signal (N2), dividing, in each time period, the direct component-free useful signal (N2) by the interval-specific effective value.

7. Method in accordance with any of the preceding claims, in which a motor current signal (M_{Motor}) is generated which indicates, as time-dependent measurement signal (M), the motor current (I) of the electromotor (1.1) of the motor-transmission unit (1).

8. Method in accordance with claim 7, in which the method step e) is carried out by
- determining the maxima of the motor current signal (M_{Motor}) and their time values,
- determining, from the distance between the maxima of the motor current signal (M_{Motor}), the number of grooves and the number of brushes of the brushed DC motor, the approximate rotational frequency (f0) or the frequency at the brushes,
- bandpass filtering the motor current signal (M_{Motor}) in the region of the approximately determined rotational frequency (f₀) or the frequency at the brushes,
- determining the maxima from the bandpass filtered motor current signal and their time values, and
- determining, from the distance between the maxima of the bandpass filtered motor current signal, the number of grooves and the number of brushes, the rotational frequency (f) of the brushed DC motor.

9. Apparatus for identifying wear and/or damage in a motor-transmission unit (1) which comprises a processing means configured to carry out the method steps of any of claims 2 to 8.

## Revendications

1. Procédé de correction d'un signal de mesure (M) dépendant du temps d'un moteur (1.1) couplé côté sortie à une transmission (1.2), pour l'influence d'une charge de sortie variable et d'une vitesse de rotation variable comprenant les étapes de procédé suivantes :
a) prendre un signal de mesure (M) dépendant du couple d'une unité moteur-transmission (1),
b) générer un signal utile (N1) sans composante continue à partir du signal de mesure (M),
c) déterminer par intervalle des valeurs efficaces à partir du signal de mesure (M),
d) générer un signal utile (N2) corrigé en charge par la division par intervalles du signal utile (N1) sans composante continue, par les valeurs efficaces spécifiques à l'intervalle,
e) déterminer par résolution dans le temps de la fréquence de rotation (f) du moteur (1) à partir du signal de mesure (M),
f) mettre à l'échelle le signal utile corrigé en charge (N2) pour une fréquence de rotation moyenne, pour générer un signal de mesure corrigé (M_{corr}) à l'aide de la fréquence de rotation déterminée (f) en échangeant des simples périodes allongées du signal utile (N2) qui présentent une fréquence plus élevée, avec des périodes de fréquence de rotation plus faibles, et
g) utiliser le signal de mesure corrigé pour détecter les défauts de l'unité moteur-transmission.

2. Procédé de reconnaissance de l'usure et/ou d'un dommage d'une unité moteur-transmission (1) avec un moteur (1.1) et une transmission (1.2) couplée à son côté de sortie, en appliquant les étapes de procédé suivantes consistant à :
- générer un signal de mesure (M) dépendant du temps avec l'unité moteur-transmission (1),
- générer un signal de mesure corrigé (M_{corr}) selon le procédé de la revendication 1,
- déterminer un spectre de fréquences (F3, F5) par une analyse de Fourier rapide FFT à partir du signal de mesure corrigé (M_{corr}),
- fournir un spectre de fréquences de référence qui est obtenu par l'analyse FFT à partir du signal de mesure corrigé d'une unité moteur-transmission sans usure et/ou sans dommage, et
- comparer le spectre de fréquences (F3, F5) du signal de mesure corrigé (M_{corr}) au spectre de fréquences de référence, et
- déterminer les caractéristiques indiquant l'usure et/ou un dommage à partir de la comparaison du spectre de fréquences du signal de mesure corrigé (F3, F5) avec le spectre de fréquences de référence, et signaler l'usure ou un dommage qui apparaissent.

3. Procédé selon la revendication 2,
selon lequel
associer une caractéristique spécifique à un composant de l'unité moteur-transmission à chaque ligne de fréquences du spectre de fréquences, généré par l'analyse FFT du signal de mesure corrigé, et
- comparer les amplitudes et/ou l'intégrale spectrale des courbes de fréquence identiques du spectre de fréquences du signal de mesure corrigé et du spectre de fréquences du spectre de fréquences de référence pour déterminer une caractéristique indiquant l'usure et/ou un dommage.

4. Procédé selon l'une des revendications précédentes,
selon lequel
on applique l'étape de procédé a) en :
- déterminant la composante continue du signal de mesure (M) et,
- en retranchant la composante continue du signal de mesure (M).

5. Procédé selon la revendication 4,
selon lequel
pour déterminer la partie continue du signal de mesure, on applique le filtre passe-bas au signal de mesure.

6. Procédé selon l'une des revendications précédentes,
selon lequel
on effectue les étapes de procédé b) et c) en :
- subdivisant le signal de mesure (M) en segments de temps successifs, inférieurs à une durée prédéfinie,
- déterminant pour chaque segment de temps, la valeur efficace spécifique à l'intervalle du signal de mesure (M), et
- divisant le signal utile (N2) sans composant continu par la valeur efficace spécifique de l'intervalle de temps, pour générer le signal utile corrigé en charge (N2) dans chaque intervalle de temps.

7. Procédé selon l'une des revendications précédentes,
selon lequel
comme signal de mesure dépendant du temps (M), on génère un signal de courant moteur (M_{Motor}) donnant le courant moteur (I) du moteur électrique (1.1) de l'unité moteur-transmission (1).

8. Procédé selon la revendication 7,
selon lequel
on exécute l'étape de procédé e) en :
- déterminant les maximums du signal de courant moteur (M_{Motor}) et des valeurs de temps correspondantes,
- déterminant par approximation la fréquence de rotation (f₀) ou la fréquence des balais, à partir de la distance des maximums du signal de courant moteur (M_{Motor}), du nombre d'encoches et du nombre de balais du moteur à courant continu à balais,
- filtrant le signal de courant moteur (M_{Motor}) dans la région du voisinage de la fréquence de rotation (f₀) déterminée ou la fréquence des balais par un filtrage passe-bande,
- déterminant les maximums à partir du signal de courant-moteur filtré en passe-bande et en déterminant les valeurs de temps, et
- déterminant le nombre d'encoches et le nombre de balais qui définissent la fréquence de rotation (f) du moteur à courant continu d'un balai à partir d'écarts maxima du signal de courant moteur filtré en bandes passantes.

9. Dispositif de détection de l'usure et/ou d'un dommage d'une unité moteur-transmission (1) qui comporte une installation de traitement pour la mise en oeuvre des étapes du procédé selon l'une des revendications 2 à 8.
